# EUROPÄISCHE PATENTSCHRIFT

(11) **EP 2 095 417 B1**
(45) Veröffentlichungstag und Bekanntmachung des Hinweises auf die Patenterteilung: **16.03.2016**
(21) Anmeldenummer: 07822743.6
(22) Anmeldetag: 20.11.2007
(51) Int. Cl.: H01L 23/18, H01L 23/043, H01L 23/48

(54) **Explosionsfester Modulaufbau für Leistungsbauelemente, insbesondere Leistungshalbleiterbauelemente und dessen Herstellung**
Explosion-proof module structure for power components, particularly power semiconductor components, and production thereof
Structure de modules à l'épreuve des explosions pour des composants de puissance, en particulier des composants semi-conducteurs de puissance et leur production

(30) Priorität: 23.11.2006 DE 102006055340
(43) Veröffentlichungstag der Anmeldung: 02.09.2009
(73) Patentinhaber: Siemens Aktiengesellschaft, 80333 München (DE)
(72) Erfinder: SCHWARZBAUER, Herbert, 81373 München (DE)
(86) Internationale Anmeldenummer: PCT/EP2007/062568
(87) Internationale Veröffentlichungsnummer: WO 2008/061980

(56) Entgegenhaltungen:
- US-A- 5 042 386
- US-A1- 2003 025 089

## Beschreibung

Die Erfindung betrifft alle Leistungsmodule, mit mindestens einem elektrischen Leistungsbauelement, insbesondere einem elektronischen Leistungshalbleiterbauelement, gemäß dem Oberbegriff des Hauptanspruchs. Leistungsbauelemente sind alle für große elektrische Ströme oder Leistungen verwendbare elektrische oder elektronische Bauelemente. Im Weiteren sind elektronische Leistungshalbleiterbauelemente beschrieben, die beispielhaft für alle möglichen Leistungsbauelemente genannt sind. Solch ein Leistungsmodul ist in dem Dokument WO-A-03/030247 beschrieben.

Auf herkömmliche Weise sind Leistungsmodule, insbesondere Module mit Leistungshalbleiterbauelementen, mittels Bonden kontaktiert. Leistungshalbleitermodule weisen insbesondere elektronische Leistungshalbleiterbauelemente auf. Derartige elektronische Leistungshalbleiterbauelemente werden zur Erzeugung von steuerbarer Energie für große Stromverbraucher verwendet und können große Lastströme schalten. Leistungshalbleiter sind gegen über Spannung, zu hohe Spannungsanstiegsgeschwindigkeit, Kurzschluss, zu hohe Stromanstiegsgeschwindigkeit und thermische Überlastung zu schützen. Insbesondere bei Kurzschluss im Stromverbraucher kann das elektronische Leistungshalbleiterbauelement aufgrund des Kurzschlussstromes zerstört werden. Bei Verwendung der herkömmlichen Bondverfahren treten bei Kurzschluss im Stromverbraucher in einem elektronischen Leistungshalbleiterbauelement in sehr kurzer Zeit sehr große Ströme auf. Dies kann zu einer sehr starken Erhitzung des elektronischen Leistungshalbleiterbauelements und ebenso zum Schmelzen führen. Die herkömmlichen Bonddrähte, die herkömmlicherweise Aluminium aufweisen, schmelzen ebenso ab oder werden abgerissen, sobald der Verguss des Moduls durch die Gasentwicklung weggesprengt wird. Aufgrund des Aufreißens der elektronischen Verbindung unter großem Stromfluss bildet sich sofort ein starker Lichtbogen, der durch die explosionsartige Erhitzung die Sprengwirkung wesentlich verstärkt, so dass ebenso benachbarte Schaltungsteile mechanisch zerstört werden können. Bei Absprengen von Emitterbonds bleibt häufig eine Gatebondung intakt, so dass die Spannung, die den Lichtbogen treibt, auch über die Gateleitungen auf die Gatesteuerung einwirken, und diese zerstören kann. Bei einer Parallelschaltung mehrer Leistungshalbleiterbauelemente oder Leistungshalbleitermodule werden die anderen Leistungshalbleiterbauelemente durch diese den Lichtbogen treibende Spannung mittels der jeweiligen Gates aufgesteuert. Die den Lichtbogen treibende Spannung wird zwar dadurch begrenzt, aber die anderen Leistungshalbleiterbauelemente werden dabei überhitzt, da diese bei der Ansteuerung über ein Kollektorpotential eine hohe Durchlassspannung aufweisen. Es kommt zu einer Zerstörung aller parallel geschalteten Leistungshalbleiterbauelementen bis zur vollständigen Unterbrechung des Stromflusses.

Herkömmlicherweise werden zum Schalten hoher Spannungen Serienschaltungen von Leistungshalbleiterbauelementen verwendet.

Bei einer Serienschaltung darf ein als Schalter arbeitendes Leistungshalbleiterbauelement im Störfall keinesfalls geöffnet bleiben, da sonst beim erneuten Einschalten die volle Spannung anliegt. Dagegen darf ein als Schalter arbeitendes Leistungshalbleiterbauelement im Störfall leitfähig bleiben, da dann an den anderen Leistungshalbleiterbauelementen in der Serienschaltung die volle Sperrspannung anliegt. Herkömmlicherweise werden für diese Anwendung Thyristoren oder auch Insulated-Gate-Bipolar-Transistoren (IGBT) mit einer aufwändigen Druckkontaktierung verwendet, da dieser Bauelementetyp bei einem Durchschmelzen nicht explodiert, sondern eine gut leitende Schweißzone ausbildet, die den Betriebsstrom weiter führen kann. Der Kontaktdruck liegt herkömmlicherweise bei über 100 kp/cm².

Es ist Aufgabe der vorliegenden Erfindung Leistungsbauelemente, insbesondere elektronische Leistungshalbleiterbauelemente wie beispielsweise Thyristoren oder IGBTs, derart bereit zu stellen, dass diese insbesondere bei Verwendung in Leistungsmodulen bei Überlastung, beispielsweise bei Kurzschluss, nicht deren Umgebung beziehungsweise keine umgebenden weiteren Bauelemente zerstören. Es sollen beispielsweise keine dazugehörigen Gatesteuerungen und/oder keine benachbarten Schaltungsteile und/oder keine parallel geschaltete Leistungshalbleiterbauelemente zerstört werden. Leistungshalbleiterbauelemente werden bevorzugt in Serienschaltung zum Schalten hoher Spannungen verwendet.

Die Aufgabe wird durch ein Leistungsmodul gemäß dem Hauptanspruch gelöst. Ein derartiges Leistungsmodul wird entsprechend den Verfahrensansprüchen hergestellt.

In den Zwischenraum der Teilchen im Hohlraum, oder bei einem Teilchen in den Raum zwischen Teilchen und Hohlraumbegrenzung, kann der Explosionsdruck bei einem Ausfall eines Leistungshalbleiterbauelementes entweichen. Metalldämpfe werden gekühlt und niedergeschlagen. Es befindet sich bevorzugt zusätzlich Luft im Hohlraum. Bei einem elektronischen Leistungshalbleiterbauelement kann sich lediglich ein Lichtbogen über maximal eine Halbleiterdicke, insbesondere Siliziumdicke, des elektronischen Leistungshalbleiterbauelementes ausbilden. Danach wird die Stromführung durch das beziehungsweise die Teilchen übernommen. Ein Auffüllen der Durchschlagstelle mit Metall wäre zwar wünschenswert, dieses wird jedoch durch einen Dampfstrom aus dem Lichtbogen behindert. Zwar ist eine dauerhafte Stromführung im Kurzschlussfall nicht sicher zu schaffen, aber das Leistungsmodul und die Ansteuerung werden bis in den Bereich von Sekunden nicht durch eine Explosion oder eine hohe Rückspannung über eine Gateleitung zerstört. Eine im Hohlraum angesammelte Vielzahl von Teilchen kann als eine Schüttung bezeichnet werden.

Weitere vorteilhafte Ausgestaltungen finden sich in den Unteransprüchen.

Gemäß einer vorteilhaften Ausgestaltung sind an der elektrischen Kontaktfläche eine weitere zur Verstärkung dienende elektrisch leitende Schicht, insbesondere Metallschicht, und daran der Hohlraum ausgebildet. Das Leistungsbauelement wird auf einer Oberseite mit einer 20 bis 50 oder 100 oder 200 µm dicken Metallschicht, wie beispielsweise Kupfer, Silber oder Nickel aufweisend überzogen. Auf diese Weise sind insbesondere eine mechanische Verstärkung und eine verbesserte zweite elektrische Kontaktierung zu der elektrischen Kontaktfläche bereitgestellt.

Gemäß einer weiteren vorteilhaften Ausgestaltung sind das Leistungsbauelement auf einem Substrat und die erste elektrische Kontaktierung von einer dem Substrat zugewandten Seite mittels mindestens einer auf dem Substrat angeordneten elektrischen Leiterbahn erzeugt. Auf diese Weise ist eine sehr kompakte Anordnung ausgebildet.

Gemäß einer weiteren vorteilhaften Ausgestaltung ist eine elektrische Isolationsschicht auf den die elektrischen Kontaktflächen beziehungsweise die elektrisch leitende Schicht umgebenden Bereichen des elektronischen Leistungsbauelements, der elektrischen Leiterbahn und des Substrats erzeugt. Die elektrische Isolation am Leistungsbauelement kann beispielsweise mittels einer strukturierten auflaminierten Isolierfolie hergestellt werden. Dabei erfolgt ein Auflaminieren einer Folie aus elektrisch isolierendem Kunststoffmaterial auf die entsprechenden Oberflächen unter Vakuum, so dass die Folie die Oberfläche mit der oder den Kontaktflächen eng anliegend bedeckt und auf dieser Oberfläche haftet. Danach erfolgt ein Freilegen jeder zu kontaktierenden elektrischen Kontaktfläche auf der Oberfläche durch Öffnen jeweiliger Fenster in der Folie und es erfolgt ein flächiges Kontaktieren jeder freigelegten Kontaktfläche mit der Schicht aus elektrisch leitendem Material. Bezüglich der Aufbringung der elektrischen Isolationsschicht sei insbesondere auf die WO03030247 verwiesen, deren Inhalt vollständig Inhalt dieser Anmeldung ist.

Gemäß einer weiteren vorteilhaften Ausgestaltung ist eine Deckschicht beziehungsweise eine Platte auf einem Rahmen, und dieser auf der elektrischen Isolationsschicht und der elektrischen Kontaktfläche beziehungsweise der Elektrisch leitenden Schicht derart herum angeordnet, dass der Hohlraum erzeugt ist und die Platte und die elektrische Kontaktfläche beziehungsweise die Elektrisch leitenden Schicht einen bestimmten Abstand zueinander aufweisen. Der Rahmen weist dabei eine geringe Höhe auf. Die Platte wird auf dem Rahmen in einem festen Abstand zu der elektrischen Kontaktfläche angeordnet. Der Rahmen kann sowohl lose bereitgestellt sein, oder ebenso mit der elektrischen Isolationsschicht oder mit der Platte verbunden sein. Der Rahmen kann ebenso Bestandteil der Isolationsschicht oder der Platte sein. Die Platte kann als eine stabile Deckschicht, vorzugsweise aus einem gut elektrisch leitenden Material, geschaffen sein.

Gemäß einer weiteren vorteilhaften Ausgestaltung weisen die Teilchen Metall, insbesondere hartes Metall, auf. Ebenso kann eine bestimmte Größenverteilung erzeugt sein. Besonders vorteilhaft sind die Teilchen kugelförmig. Auf diese Weise kann eine Schüttung besonders homogen erzeugt werden. Damit kann das Verhalten des Leistungsmoduls im Störfall optimiert werden. Kugeln aus einem harten Metall verteilen den Druck gleichmäßig. Bevorzugt ist eine große Anzahl, beispielsweise 50 bis 300, von elektrisch leitenden Teilchen. Grundsätzlich ist die Anzahl frei wählbar.

Gemäß einer weiteren vorteilhaften Ausgestaltung ist der Abstand zwischen Platte und elektrischer Kontaktfläche beziehungsweise zwischen Platte und Elektrisch leitenden Schicht etwa die drei- bis vierfache mittlere Teilchenquerschnittsausdehnung. Mittels der sorgfältigen Abstimmung des Abstandes zwischen Leistungsbauelement und Deckschicht beziehungsweise Platte einerseits und dem Durchmesser der Metallteilchen und deren Größenverteilung, kann ab einem Abstand von etwa dem drei- bis vierfachen Teilchendurchmesser eine gleichmäßige Schüttdichte erzielt werden.

Gemäß einer weiteren vorteilhaften Ausgestaltung ist zum weiteren Abbau eines Explosionsdrucks bei Überlastung des Leistungsbauelements aus dem Hohlraum mindestens ein Kanal nach außerhalb des Hohlraums ausgebildet, wobei die größte Kanalquerschnittsausdehnung kleiner als die kleinste Teilchenquerschnittsausdehnung ist. Der Explosionsdruck kann durch den befüllten Hohlraum und dem Kanal abgebaut werden.

Gemäß einer weiteren vorteilhaften Ausgestaltung weisen alle Metalloberflächen von elektrischer Kontaktfläche, von Elektrisch leitender Schicht, von den Metallteilchen und metallischer Platte eine korrosions- und oxidationsfeste Kontaktmetallisierung auf. Werden alle diese Metalloberflächen mit einer korrosions- und oxidationsfesten Kontaktmetallisierung überzogen, wie beispielsweise Nickel, Gold, Rutenium, Rhodium, Silber usw. so kann der Laststrom vom Leistungsbauelement über die Metallschüttung direkt zur Platte geleitet werden. Da keine stoffschlüssige Verbindung vorliegt, ist dieser Kontakt sehr beständig gegen Ermüdung durch Temperatur- oder Lastwechsel.

Gemäß einer weiteren vorteilhaften Ausgestaltung ist der Hohlraum unter einem Anpressdruck, insbesondere mittels Druck auf eine als Druckplatte wirkende Platte, derart gesetzt, dass eine elektrische Verbindung von elektrischer Kontaktfläche beziehungsweise Elektrisch leitender Schicht mittels der Metallteile zur Platte sichergestellt ist. Der Anpressdruck, liegt beispielsweise im Bereich von 5 bis 10 kP/cm². Auf diese Weise wird die Schaffung eines zusätzlichen Strompfades sichergestellt. Auf diese Weise kann ebenso ein neuartiges Kontaktierungssystem geschaffen werden, das ebenso bei Leistungsmodulen mit einzelnen Leistungsbauelementen eine zuverlässige Kontaktierung wie bei einem herkömmlichen Druckkontakt ermöglicht. Es ist lediglich ein im Vergleich zum Stand der Technik kleiner Kontaktdruck erforderlich. Durch diese zusätzliche Stromführungsebene können auf der Substratebene zusätzlich viele Leiterbahnen vermieden werden.

Gemäß einer weiteren vorteilhaften Ausgestaltung ist das Leistungsbauelement ein elektronisches Leistungshalbleiterbauelement wie beispielsweise ein Thyristor, ein Triac, eine Diode oder ein Insulated-Gate-Bipolar-Transistor (IGBT).

Gemäß einer weiteren vorteilhaften Ausgestaltung ist ein Gate eines Leistungshalbleiterbauelementes mittels eines elektrisch isolierten metallischen Drahtes und/oder einer metallischen Feder in einer elektrisch isolierenden Hülse elektrisch kontaktiert.

Gemäß einer weiteren vorteilhaften Ausgestaltung weist ein Leistungsmodul mehrere Leistungsbauelemente auf, die derart benachbart auf einem Substrat angeordnet sind, dass die jeweiligen Hohlräume durch eine gemeinsame elektrisch leitende Platte begrenzt sind. Auf diese Weise entsteht eine zusätzliche Stromführungsebene, mittels der elektrisch leitenden gemeinsamen Platte, so dass auf der Substratebene zusätzlich viele Leiterbahnen eingespart werden können. Die Deckplatte kann sich über mehrere Leistungsbauelemente oder ebenso über ein ganzes Leistungsmodul erstrecken.

Gemäß einer weiteren vorteilhaften Ausgestaltung ist aus mindestens einem Hohlraum mindestens ein Kanal zum Abbau eines Explosionsdrucks nach außerhalb des Hohlraumes, insbesondere zu mindestens einem benachbarten Hohlraum, ausgebildet. Beispielsweise ein hartes Metall aufweisende Kugeln verteilen den Druck gleichmäßig, beispielsweise über die Kanäle im Rahmen von Leistungsbauelement zu Leistungsbauelement. Kanäle können zwischen dem Rahmen und den anderen Teilen des Aufbaus erzeugt sein. Zum Abbau eines Explosionsdrucks dienende Kanäle müssen lediglich kleiner als der kleinste Teilchendurchmesser sein.

Gemäß einer weiteren vorteilhaften Ausgestaltung wirkt auf die gefüllten Hohlräume mittels einer als Druckplatte wirkenden gemeinsamen Platte ein Anpressdruck. Dieser kann im Bereich von beispielsweise 5 bis 10 kP/cm² liegen. Auf diese Weise wird ein neuartiges Kontaktierungssystem derart geschaffen, dass eine elektrische Verbindung von elektrischer Kontaktfläche beziehungsweise Elektrisch leitender Schicht mittels der elektrisch leitenden Teilchen zur Platte sichergestellt ist.

Gemäß einer weiteren vorteilhaften Ausgestaltung sind die Leistungsbauelemente elektrisch in Serie geschaltet, um hohe elektrische Spannungen schalten zu können.

Gemäß einer weiteren vorteilhaften Ausgestaltung werden die Leistungsbauelemente parallel angesteuert. Durch ein parallel ausgelegtes Ansteuerungskonzept können beispielsweise bei Kurzschluss unbeschädigte Modulteile auf Dauerkurzschluss geschalten werden und die Serienschaltung der Leistungsbauelemente ihren Betrieb fortsetzen.

Gemäß einer weiteren vorteilhaften Ausgestaltung werden die Teilchen über mindestens einen Einfüllkanal und/oder vor Anbringen einer Deckschicht in den Hohlraum eingebracht. Das heißt, das Volumen im Rahmen zwischen Leistungsbauelementoberfläche und Platte wird beispielsweise mit stückigen Metallteilchen, vorzugsweise Kugeln, durch eine Füllöffnung im Rahmen, in der Platte oder schon vor der Montage aufgefüllt. Damit ist das Befüllen der Hohlräume vereinfacht.

Die vorliegende Erfindung wird anhand von Ausführungsbeispielen in Verbindung mit den Figuren näher beschrieben. Es zeigen:
- Figur 1: ein erstes Ausführungsbeispiel eines erfindungsgemäßen Leistungsmoduls;
- Figur 2: ein zweites Ausführungsbeispiel eines erfindungsgemäßen Leistungsmoduls.

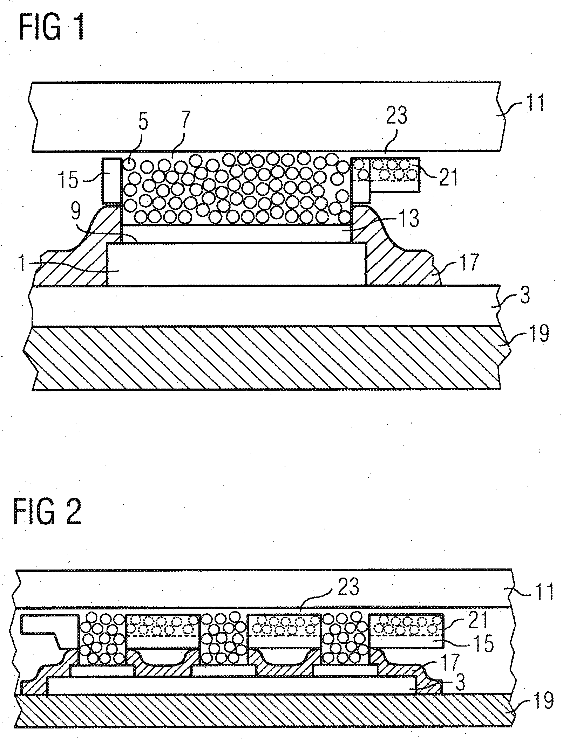

Figur 1 zeigt ein erstes Ausführungsbeispiel eines erfindungsgemäßen Leistungsmoduls. Gemäß diesem explosionsfesten Modulaufbau kann ein Explosionsdruck durch eine Füllung bestehend aus elektrisch leitenden Teilchen 5, beispielsweise Metallkugeln mit einem Durchmesser von 0,5 bis 2 mm, und einem Kanal 23 zum Druckabbau entweichen, wobei der Kanal 23 zum Druckabbau an einem Rahmen 15 entlang erzeugt ist. Gemäß diesem Ausführungsbeispiel ist ein Leistungsbauelement, insbesondere ein elektronisches Leistungshalbleiterbauelement 1 mit einer auf einer Unterseite des Leistungshalbleiterbauelements 1 erzeugten ersten elektrischen Kontaktierung für einen Laststrom geschaffen. Zudem ist auf einer Oberseite des Leistungshalbleiterbauelements 1 mittels einer elektrischen Kontaktfläche 9 eine zweite elektrische Kontaktierung für einen Laststrom erzeugt. Das Leistungshalbleiterbauelement 1 ist auf einem Substrat 19 angeordnet. Die erste elektrische Kontaktierung ist von einer dem Substrat 19 zugewandten Seite mittels mindestens einer auf dem Substrat 19 angeordneten elektrischen Leiterbahn 3 erzeugt. Die elektrische Leiterbahn kann beispielsweise eine Kupferleiterbahn sein. Vergleichbare Materialien sind ebenso verwendbar. Zum Abbau eines Explosionsdrucks und zur Leistungsaufnahme bei Überlastung des Leistungshalbleiterbauelements 1 ist an der elektrischen Kontaktfläche 9 ein mit mindestens einem elektrisch leitenden Teilchen 5 gefüllter Hohlraum 7 ausgebildet. Bevorzugt wird eine Vielzahl an elektrisch leitenden Teilchen 5 verwendet. Dabei können die Teilchen 5 als eine Schüttung erzeugt sein. Die Anzahl der Teilchen 5 kann beispielsweise im Bereich von 100 bis 1000 Teilchen 5 liegen. Die Anzahl der Teilchen 5 hängt von der Größe der Teilchen 5 und dem Volumen des Hohlraums 7 ab. In die Zwischenräume zwischen den elektrisch leitenden Teilchen 5 kann der Explosionsdruck bei einem Ausfall des Leistungshalbleiterbauelement 1 entweichen, Metalldämpfe werden gekühlt und niedergeschlagen. Zusätzlich zu dem beziehungsweise den Teilchen 5 kann sich bevorzugt Luft im Hohlraum 7 befinden. Alternative Gase sind ebenso verwendbar. Bei einem Kurzschluss kann sich lediglich ein Lichtbogen über maximal die Dicke des Leistungshalbleiterbauelements 1 ausbilden, dann wird die Stromführung durch das elektrisch leitende Teilchen 5 beziehungsweise die Vielzahl der elektrisch leitenden Teilchen 5 übernommen. Grundsätzlich kann lediglich ein elektrisch leitendes Teilchen 5 in einem Hohlraum 7 erzeugt sein. Es muss allerdings hinsichtlich Form und Material derart geschaffen sein, dass die Stromführung durch das elektrisch leitende Teilchen 5 übernommen werden kann. Bevorzugt wird eine Schüttung von elektrisch leitenden Teilchen 5 verwendet. Gemäß dem Ausführungsbeispiel nach Figur 1 ist an der elektrischen Kontaktfläche 9 eine weitere zur Verstärkung dienende, als Metallschicht ausgebildete elektrisch leitende Schicht 13 und daran der Hohlraum 7 ausgebildet. Mit dieser Metallschicht 13 wird zusätzlich sichergestellt, dass die Stromführung durch das beziehungsweise die Teilchen 5 übernommen werden kann. Zudem wird der Explosionsdruck von der Metallschicht 13 an die Zwischenräume der elektrisch leitenden Teilchen 5 weitergeleitet.

Zusätzlich ist eine elektrische Isolationsschicht 17 auf den die elektrischen Kontaktfläche 9 beziehungsweise die Metallschicht 13 umgebenden Bereichen des elektronischen Leistungshalbleiterbauelements 1, der elektrischen Leiterbahn 3 und des Substrats 19 erzeugt. Auf diese Weise wird verhindert, dass zum Leistungshalbleiterbauelement 1 parallele Ströme zwischen Leiterbahnen 3 und elektrischer Kontaktfläche 9 beziehungsweise Metallschicht 13 fließen können. Auf diese Weise kann der durch das Leistungshalbleiterbauelement 1 bei einem Kurzschluss fließende Kurzschlussstrom von dem oder den Teilchen 5 übernommen werden. Die elektrische Isolationsschicht kann beispielsweise gemäß der WO 03030247 erzeugt sein. Zudem kann die Schichtfolge Substrat 19, Leiterbahn 3, Leistungshalbleiterbauelement 1, elektrische Kontaktfläche 9, Metallverstärkung 13 und Isolation 17 gemäß der WO 03030247 geschaffen sein. Es werden folgende Schritte ausgeführt: Auflaminieren einer Folie 17 aus elektrisch isolierendem Kunststoffmaterial auf die Oberflächen des Substrats 19, der Leiterbahn 3 und des Leistungshalbleiterbauelements 1 unter Vakuum, so dass die Folie 17 die Oberflächen mit der elektrischen Kontaktfläche 9 eng anliegend bedeckt und auf dieser Oberfläche haftet, Freilegen jeder zu kontaktierenden elektrischen Kontaktfläche 9 auf der Oberfläche durch Öffnen jeweiliger Fenster in der Folie 17 und flächiges Kontaktieren jeder freigelegten elektrischen Kontaktfläche 9 mit einer Schicht 13 aus elektrisch leitendem Material. Gemäß dem Ausführungsbeispiel nach Figur 1 ist der Hohlraum 7 mittels einer Platte 11 auf einem Rahmen 15 erzeugt. Der Rahmen 15 ist auf der elektrischen Isolationsschicht 17 um die elektrische Kontaktfläche 9 beziehungsweise der Metallschicht 13 herum angeordnet. Auf diese Weise sind Platte 11 und elektrische Kontaktfläche 9 beziehungsweise Metallschicht 13 in einem bestimmten Abstand zueinander geschaffen. Die Platte 11 kann beispielsweise als eine Deckschicht erzeugt sein. Die Platte 11 kann mit einem Modulboden beziehungsweise dem Substrat 19 isoliert verschraubt sein. Das Substrat 19 kann beispielsweise als Keramikisolation geschaffen sein. Die elektrisch leitenden Teilchen 5 weisen insbesondere Metall, insbesondere hartes Metall, und/oder eine bestimmte Größenverteilung auf. Des Weiteren können die Teilchen 5 kugelförmig sein. Besonders vorteilhaft ist eine Vielzahl von Teilchen 5, die insbesondere eine Schüttung erzeugen. Besonders vorteilhaft ist der Abstand zwischen Platte 11 und elektrischer Kontaktfläche 9 beziehungsweise Metallschicht 13, die drei- bis vierfache mittlere Teilchenquerschnittsausdehnung. Zum weiteren Abbau eines Explosionsdrucks bei Überlastung des Leistungshalbleiterbauelements 1 ist aus dem Hohlraum 7 mindestens ein Kanal 23 nach außerhalb des Hohlraums 7 ausgebildet. Damit die elektrisch leitenden Teilchen 5 nicht aus dem Hohlraum 7 entweichen, ist die größte Kanalquerschnittsausdehnung kleiner als die kleinste Teilchenquerschnittsausdehnung. Damit kann bei diesem explosionsfesten Modulaufbau, ein Explosionsdruck durch die Füllung der elektrisch leitenden Teilchen 5 und dem Kanal 23 im oder am Rahmen 15 entweichen. Der Rahmen 15 ist entweder lose auf der Isolationsschicht 17 angeordnet oder ist Bestandteil der Isolation 17 oder der Platte 11. Besonders vorteilhaft ist die Platte 11 als eine Druckplatte 11 bereitgestellt. Auf diese Weise wird der Hohlraum 7 unter einem Anpressdruck derart gesetzt, dass eine elektrische Verbindung von elektrischer Kontaktfläche 9 beziehungsweise Metallschicht 13 mittels der elektrisch leitenden Teilchen 5 zu der elektrisch leitenden Platte 11 sichergestellt ist, insbesondere wenn die Oberflächen von elektrischer Kontaktfläche 9, von Metallschicht 13, von den Teilchen 5 und Platte 11 eine korrosions- und/oder oxidationsfeste Kontaktmetallisierung aufweisen. Auf diese Weise kann eine zu der Stromführungsebene der Leiterbahnen 3 auf dem Substrat 19 zusätzliche Stromführungsebene geschaffen sein. Elektronische Leistungshalbleiterbauelemente 1 können beispielsweise ein Thyristor, ein Triac oder ein Insulated-Gate-Bipolar-Transistor (IGBT) sein. Des Weiteren ist ein Gate eines Leistungshalbleiterbauelements 1 mittels eines elektrisch isolierten, elektrisch leitenden Drahtes und/oder einer elektrisch leitenden Feder in einer elektrisch isolierenden Hülse elektrisch kontaktiert. Fig. 1 zeigt zudem einen Kanal 21 zum Einfüllen der Teilchen 5. Kanal 21 wird nach dem Einfüllen geschlossen oder nach einer Verkleinerung als Kanal 23 zum Explosionsdruckabbau verwendet.

Figur 2 zeigt ein zweites Ausführungsbeispiel eines erfindungsgemäßen Leistungsmoduls. Es sind mehrere elektronische Leistungshalbleiterbauelemente 1 derart benachbart auf einem Substrat 19 angeordnet, dass die jeweiligen dazugehörigen Hohlräume 7 durch eine gemeinsame elektrisch leitende Platte 11 begrenzt sind. Figur 2 zeigt ein Substrat 19, das beispielsweise aus einer Keramik erzeugt ist. Bezugszeichen 3 zeigt eine elektrische Leiterbahn, beispielsweise eine Kupferleiterbahn. Bezugszeichen 17 zeigt eine gemeinsame Isolationsschicht 17 der drei Leistungshalbleiterbauelemente 1. Auf den drei elektronischen Leistungshalbleiterbauelementen 1 sind jeweils ein Rahmen 15 und die gemeinsame elektrisch leitende Druckplatte 11 erzeugt. Die Druckplatte kann als Metalldruckplatte 11 erzeugt sein. Bezugszeichen 21 zeigt einen Einfüllkanal für die Füllung der elektrisch leitenden Teilchen 5. Gemäß Figur 2 ist aus mindestens einem Hohlraum 7 mindestens ein Kanal 23 zum Druckabbau nach außerhalb des Hohlraums 7 zu mindestens einem benachbarten Hohlraum 7 ausgebildet. Auf die Hohlräume 7 wirkt mittels einer als Druckplatte wirkende, gemeinsame elektrisch leitende Platte 11 ein Anpressdruck. Weisen die Oberflächen von elektrischen Kontaktflächen 9, von Metallschicht 13, von Teilchen 5 und Platte 11 eine korrosions- und/oder oxidationsfeste Kontaktmetallisierung auf, so kann eine elektrische Verbindung von elektrischen Kontaktflächen 9 beziehungsweise Metallschicht 13 mittels der elektrisch leitenden Teilchen 5 zur Platte 11 sichergestellt sein. Auf diese Weise ist eine zusätzliche Stromführungsebene für eine Vielzahl von elektronischen Leistungshalbleiterbauelementen 1 geschaffen. Figur 2 zeigt ein Multi-Leistungshalbleiterbauelement-Modul mit durchgehender, leitender Druckplatte 11 als eine Strom führende Ebene. Die Rahmen 15 sind fest auf der Leistungshalbleiterbauelementisolation 17 zur Sicherung der elektrischen Isolation und Erzeugung einer Kriechstrecke angeordnet. Ein Einfüllen der elektrisch leitenden Teilchen 5, die hier beispielsweise Kugeln sind, erfolgt durch einen gemeinsamen Kanal 21. Kanal 21 kann nach dem Füllen geschlossen oder in einen Kanal 23 zum Abbau eines Explosionsdrucks im Querschnitt verkleinert werden. Gemäß einer vorteilhaften Ausgestaltung sind die elektronischen Leistungshalbleiterbauelemente 1 elektrisch in Serie geschaltet. Auf diese Weise können hohe Spannungen geschaltet werden. Weiterhin werden die elektronischen Leistungshalbleiterbauelemente 1 besonders vorteilhaft parallel angesteuert. Auf diese Weise können bei Kurzschluss unbeschädigte Leistungshalbleiterbauelemente 1 auf Dauerkurzschluss geschaltet werden und eine Serienschaltung der elektronischen Leistungshalbleiterbauelemente 1 ihren Betrieb fortsetzen. Ein Schalter darf im Störfall leitfähig bleiben, da dann die intakten Leistungshalbleiterbauelemente 1 in der Serienschaltung die volle Sperrspannung übernehmen können. Auf diese Weise wird ebenso eine Zerstörung einer Ansteuervorrichtung vermieden.

## Patentansprüche

1. Leistungsmodul, mit mindestens einem elektrischen Leistungsbauelement, insbesondere einem elektronischen Leistungshalbleiterbauelement (1), mit einer auf einer Unterseite des Leistungsbauelements erzeugten ersten elektrischen Kontaktierung für einen Laststrom und einer auf einer Oberseite des Leistungsbauelements mittels einer elektrischen Kontaktfläche (9) erzeugten zweiten elektrischen Kontaktierung für einen Laststrom, **dadurch gekennzeichnet, dass**
zum Abbau eines Explosionsdrucks und zur Leistungsaufnahme bei Überlastung des Leistungsbauelements an der elektrischen Kontaktfläche (9) ein mit mindestens einem elektrisch leitenden Teilchen (5) gefüllter Hohlraum (7) ausgebildet ist.

2. Leistungsmodul nach Anspruch 1,
**dadurch gekennzeichnet, dass**
an der elektrischen Kontaktfläche (9) eine weitere zur Verstärkung dienende elektrisch leitende Schicht (13), insbesondere Metallschicht, und daran der Hohlraum (7) ausgebildet ist.

3. Leistungsmodul nach Anspruch 1 oder 2,
**dadurch gekennzeichnet, dass**
das Leistungsbauelement auf einem Substrat (19) und die erste elektrische Kontaktierung von einer dem Substrat (19) zugewandten Seite mittels mindestens einer auf dem Substrat (19) angeordneten elektrischen Leiterbahn (3) erzeugt sind.

4. Leistungsmodul nach einem der vorangehenden Ansprüche 1 bis 3,
**dadurch gekennzeichnet, dass**
eine elektrische Isolationsschicht (17) auf den die elektrischen Kontaktfläche (9) beziehungsweise die Schicht (13) umgebenden Bereichen des elektronischen Leistungsbauelements, der elektrischen Leiterbahn (3) und des Substrats (19) erzeugt ist.

5. Leistungsmodul nach Anspruch 4,
**dadurch gekennzeichnet, dass**
der Hohlraum (7) mittels einer Platte (11) auf einem Rahmen (15), und dieser auf der elektrischen Isolationsschicht (17) um die elektrische Kontaktfläche (9) herum angeordnet, erzeugt ist, wobei Platte (11) und elektrische Kontaktfläche (9) einen bestimmten Abstand zueinander aufweisen.

6. Leistungsmodul nach einem der Ansprüche 1 bis 5,
**dadurch gekennzeichnet, dass**
die Teilchen (5) Metall, insbesondere hartes Metall, und/oder eine bestimmte Größenverteilung aufweisen und/oder kugelförmig sind und/oder eine Vielzahl von Teilchen (5) verwendet wird.

7. Leistungsmodul nach Anspruch 5 oder 6,
**dadurch gekennzeichnet, dass**
der Abstand zwischen Platte (11) und elektrischer Kontaktfläche (9) etwa die drei- bis vierfache mittlere Teilchenquerschnittsausdehnung ist.

8. Leistungsmodul nach einem der Ansprüche 1 bis 7,
**dadurch gekennzeichnet, dass**
zum weiteren Abbau eines Explosionsdrucks bei Überlastung des Leistungsbauelements aus dem Hohlraum (7) mindestens ein Kanal (23) nach außerhalb des Hohlraums (7) ausgebildet ist, wobei die größte Kanalquerschnittausdehnung kleiner als die kleinste Teilchenquerschnittsausdehnung ist.

9. Leistungsmodul nach einem der Ansprüche 1 bis 8,
**dadurch gekennzeichnet, dass**
die Oberflächen von elektrischer Kontaktfläche (9), von Schicht (13), von Teilchen (5) und Platte (11) eine korrosions und oxidationsfeste Kontaktmetallisierung aufweisen.

10. Leistungsmodul nach einem der Ansprüche 5 bis 9,
**dadurch gekennzeichnet, dass**
der Hohlraum (7) unter einen Anpressdruck, insbesondere mittels Druck auf eine als Druckplatte wirkenden Platte (11), derart gesetzt ist, dass eine elektrische Verbindung von elektrischer Kontaktfläche (9) beziehungsweise Schicht (13) mittels der elektrisch leitenden Teilchen (5) zur Platte (11) sichergestellt ist.

11. Leistungsmodul nach einem der Ansprüche 1 bis 10,
**dadurch gekennzeichnet, dass**
das elektronische Leistungshalbleiterbauelement (1) ein Thyristor, ein Triac, eine Diode oder ein Insulated-Gate-Bipolar-Transistor (IGBT) ist.

12. Leistungsmodul nach einem der Ansprüche 1 bis 11,
**dadurch gekennzeichnet, dass**
ein Gate des Leistungshalbleiterbauelements (1) mittels eines elektrisch isolierten, elektrisch leitenden Drahtes und/oder einer elektrisch leitenden Feder in einer elektrisch isolierenden Hülse elektrisch kontaktiert ist.

13. Leistungsmodul nach einem der Ansprüche 2 bis 12,
**dadurch gekennzeichnet, dass**
mehrere Leistungsbauelemente derart benachbart auf dem Substrat (19) angeordnet sind, dass die jeweiligen Hohlräume (7) durch eine gemeinsame elektrisch leitende Platte (11) begrenzt sind.

14. Leistungsmodul nach Anspruch 13,
**dadurch gekennzeichnet, dass**
aus mindestens einem Hohlraum (7) mindestens ein Kanal (23) zum Abbau eines Explosionsdrucks nach außerhalb des Hohlraums (7), insbesondere zu mindestens einem benachbarten Hohlraum, (7) ausgebildet ist.

15. Leistungsmodul nach Anspruch 13 oder 14,
**dadurch gekennzeichnet, dass**
auf die Hohlräume (7) mittels einer als Druckplatte wirkenden, gemeinsamen elektrisch leitenden Platte (11) ein Anpressdruck wirkt.

16. Leistungsmodul nach einem der Ansprüche 13 bis 15,
**dadurch gekennzeichnet, dass**
die Leistungsbauelemente elektrisch in Serie geschaltet sind.

17. Leistungsmodul nach einem der Ansprüche 13 bis 16,
**dadurch gekennzeichnet, dass**
die Leistungsbauelemente parallel angesteuert sind.

18. Verfahren zur Herstellung eines Leistungsmoduls nach einem der vorangehenden Ansprüche 1 bis 17, mit den Schritten,
- Erzeugen einer auf einer Unterseite des Leistungsbauelements erzeugten ersten elektrischen Kontaktierung für einen Laststrom,
- Erzeugen einer auf einer Oberseite des Leistungsbauelements mittels einer elektrischen Kontaktfläche (9) ausgebildeten zweiten elektrischen Kontaktierung für einen Laststrom, und
- Erzeugen eines zum Abbau eines Explosionsdrucks und zur Leistungsaufnahme bei Überlastung des Leistungsbauelements dienenden, an der elektrischen Kontaktfläche (9) angeordneten, mit mindestens einem elektrisch leitenden Teilchen (5) gefüllten Hohlraums (7).

19. Verfahren zur Herstellung eines Leistungsmoduls nach Anspruch 18, **dadurch gekennzeichnet, dass**
die elektrisch leitenden Teilchen (5) über mindestens einen Einfüllkanal (21) und/oder vor Anbringen einer Platte (11) in den Hohlraum (7) eingebracht werden.

## Claims

1. Power module, with a least one electrical power component, especially an electronic power semiconductor component (1), with a first electrical contact for a load current created on an underside of the power component and a second electrical contact for a load current created on an upper side of the power component by means of an electrical contact surface (9),
**characterised in that**,
to reduce an explosion pressure and to receive the power on overload of a power component, a cavity (7) filled with at least one electrically-conducting particle (5) is arranged on the electrical contact surface (9).

2. Power module according to claim 1,
**characterised in that**
a further electrically-conducting layer (13), especially a metal layer, is formed on the electrical contact surface (9) and the cavity (7) is formed thereon.

3. Power module according to 1 or 2,
**characterised in that**
the power component is created on a substrate (19) and the first electrical contact is created from a side facing the substrate (19) by means of at least one electrical conductor track (3) arranged on the substrate (19).

4. Power module according to one of the previous claims 1 to 3,
**characterised in that**
an electrical insulation layer (17) is created in the areas of the electronic power component, the electrical conductor track (3) and the substrate (19) surrounding the electrical contact surface (9) or the layer (13) respectively.

5. Power module according to claim 4,
**characterised in that**
the cavity (7) is created by means of a plate (11) on a frame (15), and this is arranged on the electrical insulation layer (17) around the electrical contact surface (9), with plate (11) and electrical contact surface (9) being at a specific distance from each other.

6. Power module according to one of claims 1 to 5,
**characterised in that**
the particles (5) are metal, especially hard metal, and/or have a specific size distribution and/or are spherical in shape and/or a plurality of particles (5) is used.

7. Power module according to claim 5 or 6,
**characterised in that**
the space between plate (11) and electrical contact surface (9) is approximately three to four times the average particle cross-sectional extent.

8. Power module according to one of claims 1 to 7,
**characterised in that**,
for further reduction of an explosion pressure in the event of an overload of a power component, at least one channel (23) is embodied from the cavity (7) to outside the cavity (7), with the largest cross-sectional extent of the channel being smaller than the smallest particle cross-sectional extent.

9. Power module according to one of claims 1 to 8,
**characterised in that**
the surfaces of electrical contact surface (9), of layer (13), of particle (5) and plate (11) have a corrosion-proof und oxidation-proof contact metallisation.

10. Power module according to one of claims 5 to 9,
**characterised in that**
the cavity (7) is placed under a compression pressure, especially by means of pressure on a plate (11) acting as a pressure plate such that an electrical connection from the electrical contact surface (9) or layer (13) respectively to the plate (11) is ensured by means of the electrically-conducting particles (5).

11. Power module according to one of claims 1 to 10,
**characterised in that**
the electronic power semiconductor component (1) is a thyristor, a triac, a diode or an Insulated-Gate-Bipolar-Transistor (IGBT).

12. Power module according to one of claims 1 to 11,
**characterised in that**
the gate of the power semiconductor component (1) is electrically contacted by means of an electrically-insulating, electrically-conducting wire and/or an electrically-conducting spring in an electrically-insulating sleeve.

13. Power module according to one of claims 2 to 12,
**characterised in that**
a number of power components are arranged next to each other on the substrate (19) such that the respective cavities (7) are delimited by a common electrically-conducting plate (11).

14. Power module according to claim 13,
**characterised in that**,
to reduce an explosion pressure, at least one channel (23) is embodied from at least one cavity (7) to outside the cavity (7), especially to a least one adjacent cavity (7).

15. Power module according to claim 13 or 14, **characterised in that**
a compression pressure operates on the cavities (7) by means of a common electrically-conducting plate (11) acting as a pressure plate.

16. Power module according to one of claims 13 to 15,
**characterised in that**
the power components are connected electrically in series.

17. Power module according to one of claims 13 to 16,
**characterised in that**
the power components are activated in parallel.

18. Method for producing a power module according to one of the previous claims 1 to 17, with the following steps,
- creation of a first electrical contact for a load current created on the underside of the power component,
- creation of a second electrical contact for a load current arranged on the upper side of the power component by means of an electrical contact surface (9), and
- creation of a cavity (7) for reducing an explosion pressure and used for receiving the power on overload of the power component, arranged on the electrical contact surface (9), filled with a least one electrically-conducting particle (5).

19. Method for producing a power module according to claim 18,
**characterised in that**
the electrically-conducting particles (5) are introduced into the cavity (7) via at least one fill channel (21) and/or before fitting a plate (11).

## Revendications

1. Module de puissance ayant au moins un composant électrique de puissance, notamment un composant (1) électronique de puissance à semiconducteur, ayant une première mise en contact électrique, produite d'un côté inférieur du composant de puissance, pour un courant de charge et une deuxième mise en contact électrique, produite d'un côté supérieur du composant de puissance au moyen d'une surface ( 9 ) de contact électrique, pour un courant de charge, **caractérisé en ce que**, pour supprimer une pression explosive et pour absorber de la puissance si le composant de puissance est surchargé, on forme sur la surface ( 9 ) de contact électrique une cavité ( 7 ) emplie au moins d'une particule ( 5 ) conductrice de l'électricité.

2. Module de puissance suivant la revendication 1,
**caractérisé en ce que**
on forme sur la surface ( 9 ) de contact électrique une autre couche ( 13 ) conductrice de l'électricité et servant à l'amplification, notamment une couche métallique, et sur celle-ci la cavité ( 7 ).

3. Module de puissance suivant la revendication 1 ou 2,
**caractérisé en ce que**
l'on produit le composant de puissance sur un substrat ( 19 ) et la première mise en contact électrique d'un côté tourné vers le substrat ( 19 ) à l'aide d'au moins une piste ( 3 ) conductrice de l'électricité mise sur le substrat ( 19 ).

4. Module de puissance suivant l'une des revendications précédentes 1 à 3,
**caractérisé en ce que**
l'on produit une couche ( 17 ) isolante du point de vue électrique sur les parties, entourant la surface ( 9 ) de contact électrique ou la couche ( 13 ), du composant électronique de puissance, de la piste ( 3 ) conductrice électrique et du substrat ( 19 ).

5. Module de puissance suivant la revendication 4,
**caractérisé en ce que**
l'on produit la cavité ( 7 ) au moyen d'une plaque ( 11 ) sur un cadre ( 15 ) et l'on met celui-ci sur la couche ( 17 ) isolante du point de vue électrique autour de la surface ( 9 ) de contact électrique, la plaque ( 11 ) et la surface ( 9 ) de contact électrique ayant l'une par rapport à l'autre une distance définie.

6. Module de puissance suivant l'une des revendications 1 à 5,
**caractérisé en ce que**
les particules ( 5 ) comportent du métal, notamment du métal dur, et/ou ont une granulométrie définie et/ou sont sphériques et/ou on utilise une pluralité de particules ( 5 ).

7. Module de puissance suivant la revendication 5 ou 6,
**caractérisé en ce que**
la distance entre la plaque ( 11 ) et la surface ( 9 ) de contact électrique représente environ du tiers au quadruple de l'étendue moyenne de la section transversale des particules.

8. Module de puissance suivant l'une des revendications 1 à 7,
**caractérisé en ce que**,
pour supprimer davantage une pression explosive si le composant de puissance est en surcharge, on forme à partir de la cavité ( 7 ) au moins un canal ( 23 ) allant vers l'extérieur de la cavité ( 7 ), l'étendue la plus grande en section transversale du canal étant plus petite que l'étendue la plus petite en section transversale de la particule.

9. Module de puissance suivant l'une des revendications 1 à 8,
**caractérisé en ce que**
les surfaces de la surface ( 9 ) de contact électrique de la couche ( 13 ) de particules ( 5 ) et de la plaque ( 11 ) ont une métallisation de contact résistant à la corrosion et à l'oxydation.

10. Module de puissance suivant l'une des revendications 5 à 9,
**caractérisé en ce que**
l'on met la cavité ( 7 ) sous une pression d'application, notamment au moyen d'une pression sur une plaque ( 11 ) servant de plaque d'application d'une pression, de manière à assurer une liaison électrique de la surface ( 9 ) de contact électrique ou de la couche ( 13 ) à la plaque ( 11 ) au moyen des particules ( 5 ) conductrices de l'électricité.

11. Module de puissance suivant l'une des revendications 1 à 10,
**caractérisé en ce que**
le composant ( 1 ) électronique de puissance à semiconducteur est un thyristor, un triac, une diode ou un insulated-gate-bipolar-transistor ( IGBT ).

12. Module de puissance suivant l'une des revendications 1 à 11,
**caractérisé en ce que**
une grille du composant ( 1 ) de puissance à semiconducteur est, au moyen d'un fil métallique isolé électriquement et conducteur d'électricité et/ou d'un ressort conducteur de l'électricité, mise en contact électriquement dans un manchon isolant du point de vue électrique.

13. Module de puissance suivant l'une des revendications 2 à 12,
**caractérisé en ce que**
plusieurs composants de puissance sont montés sur le substrat ( 19 ) en étant voisins de manière à délimiter les cavités ( 7 ) respectives par une plaque ( 11 ) commune conductrice de l'électricité.

14. Module de puissance suivant la revendication 13,
**caractérisé en ce qu'**
il est formé, à partir d'au moins une cavité ( 7 ), au moins un canal ( 23 ) de suppression d'une pression explosive allant vers l'extérieur de la cavité ( 7 ), notamment vers au moins une cavité ( 7 ) voisine.

15. Module de puissance suivant la revendication 13 ou 14,
**caractérisé en ce qu'**
une pression d'application agit sur les cavités ( 7 ) à l'aide d'une plaque ( 11 ) commune conductrice de l'électricité, agissant comme plaque d'application d'une pression.

16. Module de puissance suivant l'une des revendications 13 à 15,
**caractérisé en ce que**
les composants de puissance sont montés électriquement en série.

17. Module de puissance suivant l'une des revendications 13 à 16,
**caractérisé en ce que**
les composants de puissance sont commandés en parallèle.

18. Procédé de fabrication d'un module de puissance suivant l'une des revendications précédentes 1 à 17, comprenant les stades dans lesquels :
- on produit une première mise en contact électrique pour un courant de charge sur un côté inférieur du composant de puissance,
- on produit une deuxième mise en contact électrique pour un courant de charge sur un côté supérieur du composant de puissance au moyen d'une surface ( 9 ) de contact électrique et
- on produit une cavité ( 7 ) emplie d'au moins une particule ( 5 ) conductrice de l'électricité sur la surface ( 9 ) de contact électrique, pour supprimer une pression explosive et pour absorber de la puissance en cas de surcharge du composant de puissance.

19. Procédé de fabrication d'un module de puissance suivant la revendication 18, **caractérisé en ce que**
l'on introduit dans la cavité ( 7 ) les particules ( 5 ) conductrices de l'électricité par au moins un canal ( 21 ) de remplissage et/ou avant de mettre une plaque ( 11 ) dans la cavité ( 7 ).
